# EUROPEAN PATENT SPECIFICATION

(11) **EP 2 645 441 B1**
(45) Date of publication and mention of the grant of the patent: **14.12.2016**
(21) Application number: 13161001.6
(22) Date of filing: 26.03.2013
(51) Int. Cl.: H01L 45/00, C23C 18/12, G02F 1/055, H01G 4/12, H01L 29/78, H01L 37/02, H01L 41/09, H01L 41/187, H01L 41/318, H02N 2/00, H03H 9/02, H01G 7/06, H01G 4/33

(54) **Method of manufacturing PZT-based ferroelectric thin film**
Verfahren zur Herstellung einer ferroelektrischen Dünnschicht auf PZT-Basis
Procédé de fabrication d'un film mince ferroélectrique à base PZT

(30) Priority: 30.03.2012 JP 2012078916
(43) Date of publication of application: 02.10.2013
(73) Proprietor: Mitsubishi Materials Corporation, Chiyoda-ku Tokyo 100-8117 (JP)
(72) Inventor: Doi, Toshihiro, Naka-shi, Ibaraki 311-0102 (JP); Sakurai, Hideaki, Naka-shi, Ibaraki 311-0102 (JP); Watanabe, Toshiaki, Sanda-shi, Hyogo 669-1339 (JP); Soyama, Nobuyuki, Naka-shi, Ibaraki 311-0102 (JP)
(74) Representative: Gille Hrabal

(56) References cited:
- EP-A1- 0 897 901
- US-A1- 2009 077 782

## Description

### [Technical Field]

The present invention relates to a method of manufacturing a PZT-based ferroelectric thin film by forming, calcining and firing a relatively thick film on a substrate using a Chemical Solution Deposition (CSD) method.

### [Background Art]

In recent years, a method of forming a PZT-based ferroelectric thin film-forming composition having a relatively thick film (thick film) which is 100 nm or more per layer by coating a solution including a PZT-based ferroelectric composition on a substrate once using a CSD method has been introduced. This is because there is a necessity for a method in which the piezoelectric characteristics of a piezoelectric element or the like using a PZT-based ferroelectric thin film as a material are improved, and a method of manufacturing a PZT-based ferroelectric thin film in which the crystal orientation is (100) or (111) at a low cost. However, for the relatively thick film formed by coating a solution once, cracking is liable to occur in the film, and there is a tendency for the film density to decrease during manufacturing of the film.

Therefore, in order to solve such disadvantages, addition of a volatile alcohol, such as propylene glycol or ethanol, to a solution of a PZT-based ferroelectric thin film-forming composition for improving the viscosity of the solution is attempted (for example, refer to Patent Document 1). In addition, an attempt of adding a Drying Control Chemical Additive (DCCA), crystalline fine powder, or the like to a solution of a PZT-based ferroelectric thin film-forming composition is being made (for example, refer to Non Patent Document 1). Furthermore, an attempt of adding to a PZT-based ferroelectric thin film-forming composition a macromolecule, such as PVP, for alleviating generation of stress in order to prevent cracking, and carrying out calcination and, subsequently, firing in a single step using infrared rays and/or heat from an electric heater is made (for example, refer to Non Patent Document 2).

### [Related art document]

### [Patent Document]

[Patent Document 1] Japanese Unexamined Patent Application Publication No. 2001-261338 (Claim 1, Paragraphs [0018] to [0025], Table 1)

### [Non Patent Document]

[Non Patent Document 1] "Collection of know-how for controlling structures in a sol-gel method for achieving objects," published by Technical Information Institute Co., Ltd., pp. 60 to 63
[Non Patent Document 2] JSol-Gel Technol (2008) 47, pp. 316 to 325

Further methods of the prior art are described by EP 0 897 901 A1 and US 2009 / 0077782 A1.

### [Disclosure of the Invention]

### [Problem that the Invention is to Solve]

However, the inventors found that, in a case in which a thick film is formed by coating a PZT-based ferroelectric thin film-forming composition once using a sol-gel solution not including highly toxic 2-methoxyethanol with industrialization in mind, and this thick film is calcined and, subsequently, fired in a single step, the obtained PZT-based ferroelectric thin film does not become a dense and highly crystal-oriented thin film. In addition, in order to solve this problem, the inventors carried out intensive studies regarding characteristic temperature patterns for which infrared rays are used in a calcination step with an assumption that a certain additive is added to a solution of a PZT-based ferroelectric thin film-forming composition, and, consequently, reached the invention.

An object of the invention is to provide a method of manufacturing a dense and highly crystal-oriented PZT-based ferroelectric thin film in which cracking does not occur even when a PZT-based ferroelectric thin film having a relatively thick film which is 100 nm or more per layer is formed by carrying out coating, calcination, and firing once using a CSD method represented by a sol-gel method.

### [Means for Solving the Problems]

A first aspect of the invention is a method of manufacturing a PZT-based ferroelectric thin film on a lower electrode according to claim 1.

A second aspect of the invention is an invention based on the first aspect, in which, furthermore, a first temperature-increase rate until the first holding step is reached is in a range of 1°C/second to 10°C/second, and a second temperature-increase rate until the temperature is increased from the first holding step and the second holding step is reached is in a range of 1°C/second to 100°C/second.

A third aspect of the invention is an invention based on the first or second aspect, in which a holding temperature during the firing is in a temperature range of 550°C to 800°C, and a temperature-increase rate through the holding time is in a range of 2.5°C/second to 150°C/second.

A fourth aspect of the invention is an invention based on the first to third aspects, in which, furthermore, a film thickness of the ferroelectric thin film is in a range of 150 nm to 400 nm.

A fifth aspect of the invention is a complex electronic component of a thin film capacitor, a capacitor, an IPD, a DRAM memory capacitor, a laminate capacitor, a gate insulator of a transistor, an non-volatile memory, a pyroelectric infrared detecting element, a piezoelectric element, an electro-optic element, an actuator, a resonator, an ultrasonic motor, or an LC noise filter element having the PZT-based ferroelectric thin film which is based on the fourth aspect.

### [Advantage of the Invention]

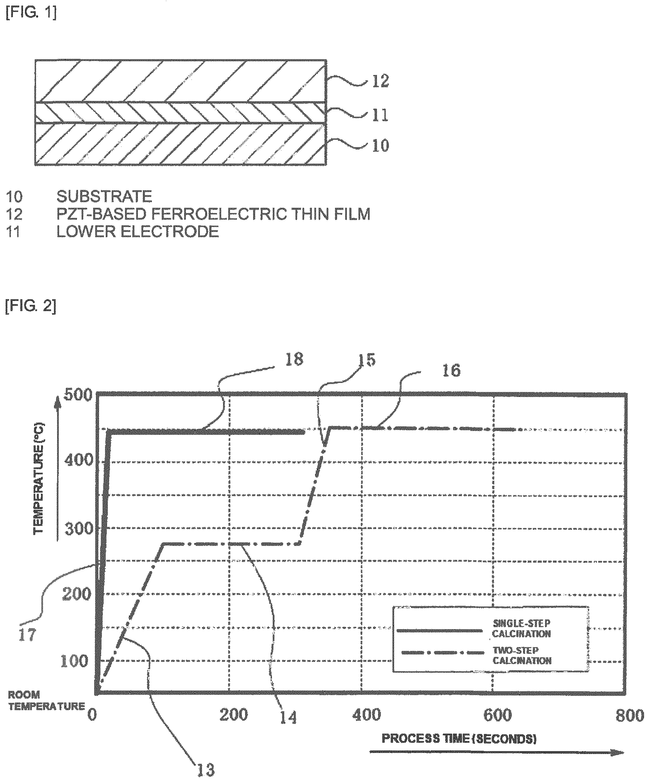

The method of the first aspect of the invention is a method of manufacturing a PZT-based ferroelectric thin film 12 on a lower electrode 11 by coating, calcining, and then firing so as to crystallize a PZT-based ferroelectric thin film-forming composition on the lower electrode 11 of a substrate 10 having the lower electrode 11 in which a crystal plane is oriented in a (111) axis direction as shown in Figs. 1 and 2, in which the calcination is carried out using infrared rays, and at least a first holding step 14 in which the temperature of the composition is increased from a temperature in a temperature range of 0°C to 150°C (or room temperature) and the composition is held at a temperature in a temperature range of 200°C to 350°C, and a second holding step 16 in which the temperature of the composition is increased from a holding temperature of the first holding step 14 and the composition is held at a temperature in a temperature range of 350°C to 500°C higher than the holding temperature of the first holding step 14 are included. As such, since the holding steps having a plurality of calcination temperatures including the first holding step 14 and the second holding step 16 are provided during the calcination (hereinafter referred to as the "two-step calcination". Meanwhile, calcination of the related art having a single-step holding will be referred to as the "one-step calcination"), and infrared rays are used as a heat source for calcination, the progress of thermal decomposition, thermal expansion, thermal contraction, and the like during the calcination of the PZT-based ferroelectric thin film is set to be slow, and therefore it is possible to prevent cracking and provide a method of manufacturing a dense PZT-based ferroelectric thin film.

In the method of the second aspect of the invention, since the first temperature-increase rate 13 from the initial temperature, such as room temperature, to until the first holding step 14 is reached and the second temperature-increase rate 15 from the first holding step 14 to until the second holding step 16 is reached are set in the respective predetermined ranges, the occurrence of cracking derived from large stress generated due to an excess temperature-increase rate, abrupt thermal decomposition or degassing is prevented, and a denser PZT-based ferroelectric thin film can be obtained.

In the method of the third aspect of the invention, since the holding temperature during the firing is in a temperature range of 550°C to 800°C, and a temperature-increase rate through the holding time is in a range of 2.5°C/second to 150°C/second, thereby setting the temperature-increase rate from the second holding step 16 to the holding temperature of the firing in a predetermined range, the occurrence of cracking caused by thermal expansion and the like resulting from an excess temperature-increase rate, abrupt thermal decomposition or degassing is prevented, and a denser PZT-based ferroelectric thin film can be obtained.

### [Brief Description of the Drawings]

Fig. 1 is a cross-sectional view schematically showing a state in which the PZT-based ferroelectric thin film of the invention is disposed on a substrate and a lower electrode.
Fig. 2 is a graph schematically showing the temperature profile of calcination according to the two-step calcination of the invention having holding temperature ranges in two places (dashed line) and the temperature profile of calcination of a single-step calcination of the related art having a holding temperature range in one place (solid line).
Fig. 3 is a graph schematically exemplifying examples of the first temperature-increase rate having three inclinations in accordance with the temperature profile of the two-step calcination of the invention.
Fig. 4 shows the cross-sectional structure of a PZT-based ferroelectric thin film manufactured using the manufacturing method according to the invention using a SEM image.
Fig. 5 shows the cross-sectional structure of a PZT-based ferroelectric thin film manufactured using a technique of the related art using a SEM.
Fig. 6 is an XRD chart of crystals of PZT-based ferroelectric thin films manufactured in Example 6 and Comparative example 2.

### [Best Mode for Carrying Out the Invention]

The present embodiment according to the method of manufacturing a PZT-based ferroelectric thin film will be described in divided categories of "composition preparation step", "coating step", "calcination step" and "firing step".

### <Composition preparation step>

A PZT-based ferroelectric thin film-forming composition is prepared using an organic metal compound solution which contains raw materials for configuring a complex metal oxide dissolved in an organic solvent so as to obtain a ratio at which a desired metal atomic ratio is supplied. Meanwhile, the "PZT-based" ferroelectric thin film includes ferroelectric compositions other than PZT, such as PLZT, PMnZT, and PNbZT.

The raw material of the complex metal oxide is preferably a compound in which organic groups are bonded to the respective metal elements of Pb, La, Zr and Ti through oxygen or nitrogen atoms thereof. Examples thereof include one or two or more selected from a group consisting of metal alkoxides, metal diol complexes, metal triol complexes, metal carboxylates, metal β-diketonate complexes, metal β-diketoester complexes, metal β-iminoketo complexes and metal amino complexes. A particularly preferable compound is a metal alkoxide, a partial hydrolysate thereof, an organic acid salt. Among the above, examples of a Pb compound and a La compound include acetates (lead acetate: Pb(OA_{c})₂, lanthanum acetate: La(OA_{c})₃), lead diisoproproxide: Pb(OiPr)₂, lanthanum triisopropoxide: La(OiPr)₃, and the like. Examples of a Ti compound include alkoxides such as titanium tetraethoxide: Ti(OEt)₄, titanium tetraisopropoxide: Ti(OiPr)₄, titanium tetra n-butoxide: Ti(OiBu)₄, titanium tetraisobutoxide: Ti(OiBu)₄, titanium tetra t-butoxide: Ti(OtBu)₄, and titanium dimethoxy diisopropoxide: Ti(OMe)₂(OiPr)₂. As a Zr compound, the same alkoxides as for the Ti compound are preferable. The metal alkoxide may be used as it is, but a partial hydrolysate thereof may be used in order to accelerate decomposition.

A composition for obtaining a concentration suitable for coating by dissolving the raw materials in an appropriate solvent at a ratio corresponding to the desired PZT-based ferroelectric thin film composition is preferably prepared in the following liquid synthesis flow. A Zr source, a Ti source and a stabilizer are put into a reaction vessel, and are refluxed in a nitrogen atmosphere. Next, a Pb source is added to the refluxed compound, a solvent is added, the solution is refluxed in a nitrogen atmosphere, is distilled under reduced pressure so as to remove byproducts, then, propylene glycol is further added to the solution so as to adjust the concentration, and, furthermore, n-butanol is added to this solution.

The solvent of the PZT-based ferroelectric thin film used here is appropriately determined depending on the raw materials to be used, and general examples thereof that can be used include carboxylic acids, alcohols (for example, propylene glycol which is a multivalent alcohol), esters, ketones (for example, acetone and methyl ethyl ketone), ethers (for example, dimethyl ether and diethyl ether), cycloalkanes (for example, cyclohexane and cyclohexanol), aromatic solvents (for example, benzene, toluene and xylene), other tetrahydrofuran, or a mixed solvent of two or more thereof.

Specific examples of the carboxylic acids that is preferably used include n-butyric acid, α-methyl butyric acid, i-valeric acid, 2-ethyl butyric acid, 2,2-dimethyl butyric acid, 3,3-dimethyl butyric acid, 2,3-dimethyl butyric acid, 3-methyl pentanoic acid, 4-methyl pentanoic acid, 2-ethyl pentanoic acid, 3-ethyl pentanoic acid, 2,2-dimethyl pentanoic acid, 3,3-dimethyl pentanoic acid, 2,3-dimethyl pentanoic acid, 2-ethyl hexanoic acid, and 3-ethyl hexanoic acid.

In addition, ethyl acetate, propyl acetate, n-butyl acetate, sec-butyl acetate, tert-butyl acetate, isobutyl acetate, n-amyl acetate, sec-amyl acetate, tert-amyl acetate or isoamyl acetate is preferably used as the ester, and 1-propanol, 2-propanol, 1-butanol, 2-butanol, isobutyl alcohol, 1-pentanol, 2-pentanol, 2-methyl-2-pentanol, or 2-methoxy ethanol is preferably used as the alcohol.

The total concentration of an organic metallic compound in the organic metal compound solution of the composition for forming the PZT-based ferroelectric thin film is preferably set to approximately 0.1 mass% to 23 mass% in terms of the amount of the metal oxide.

In this organic metal compound solution, a β-diketone (for example, acetyl acetone, heptafluorobutanoyl pivaloyl methane, dipivaloyl methane, trifluoroacetyl acetone, benzoyl acetone, or the like), a β-ketonic acid (for example, acetoacetic acid, propionyl acetate, benzoyl acetate, or the like), a β-ketoester (for example, a lower alkyl ester such as methyl, propyl, or butyl of the above ketonic acid), an oxyacid (for example, lactic acid, glycolic acid, α-hydroxybutyric acid, salicylic acid, or the like), a lower alkyl ester of the above oxyacid, an oxyketone (for example, diacetone alcohol, acetoine, or the like), a diol, a triol, a higher carboxylic acid, an alkanol amine (for example, diethanolamine, triethanolamine, monoethanolamine), a multivalent amine, or the like may be added as a stabilizer as necessary at a (the number of molecules of the stabilizer)/(the number of metal atoms) of approximately 0.2 to 3.

In addition, the PZT-based ferroelectric thin film-forming composition may include a β-diketone and a multivalent alcohol. Among the above, acetyl acetone is particularly preferable as the β-diketone, and propylene glycol is particularly preferable as the multivalent alcohol.

Furthermore, it is preferable to remove particles from the organic metal compound solution prepared above using a filtration treatment or the like.

### <Coating step>

In order to manufacture a PZT-based ferroelectric thin film in the coating step, a spin coating method, which is a CSD method and uses a spin coater, is preferably used, the solution manufactured in the composition preparation step is added dropwise on a Pt film of the lower electrode in which a SiO₂ film, a TiO₂ film and a Pt film are sequentially formed on a Si substrate set on a spin coat, and spin coating is carried out at 1500 rpm to 2000 rpm for 60 seconds, thereby forming a coated film on the Pt substrate. After coating, the substrate on which the coated film is formed is disposed on a hot plate at 150°C, heated for 3 minutes, and a solvent having a low boiling point or adsorbed water molecules are removed, thereby making the coated film into a gel-state film (hereinafter referred to as the "gel film"). Other CSD method other than the spin coating method, such as a dip coating method or a Liquid Source Misted Chemical Deposition (LSMCD) method, may be appropriately applied instead of the spin coating.

### <Calcination step>

In the calcination step, the solvent or moisture in the gel film are removed, and the organic metal compound is thermally decomposed or hydrolyzed so as to be converted into a complex oxide. Therefore, the calcination is carried out in the air, an oxidation atmosphere, or a water vapor-containing atmosphere. In the present specification, the "calcination step" is defined as a step for firing the gel film at a temperature lower than the temperature at which a perovskite phase begins to be formed in a desired PZT-based ferroelectric thin film as a phase of the complex oxide, and, meanwhile, the "firing step" described below is defined as a step for forming a perovskite phase in the PZT-based ferroelectric thin film.

Furthermore, the two-step calcination of the embodiment will be described in detail with reference to Fig. 2, comparing to a single-step calcination of a technique of the related art.

Fig. 2 is a temperature profile of the calcination step having parameters of the process time of calcination (seconds) in the horizontal axis and the calcination temperature (°C) in the vertical axis. In Fig. 2, the dashed line indicates the temperature profile of the two-step calcination of the embodiment, and the solid line indicates the temperature profile of a single-step calcination of a technique of the related art.

As is evident from Fig. 2, in the single-step calcination of a technique of the related art, the temperature is increased at a temperature-increase rate 17 at which the calcination temperature is monotonously and abruptly increased to the holding temperature (450°C in Fig. 2) using RTA in order for productivity improvement, and then, a holding temperature 18 is maintained for a certain holding time. On the other hand, in the two-step calcination according to the calcination step of the embodiment, calcination is carried out in a manner in which the holding temperature areas are provided at two places of the first holding step 14 and the second holding step 16, the temperature is increased from a relatively low certain temperature, such as room temperature, to the first holding step 14 at a very slow temperature-increase rate (a first temperature-increase rate 13) using RTA, and, furthermore, the temperature is increased from the first holding step 14 to the second holding step 16 at preferably the second temperature-increase rate 15 faster than the first temperature-increase rate. In the embodiment, the number of the temperature holding steps is set to two, but the temperature holding steps may be provided at three or more places as necessary in consideration of the composition of the raw materials, the mixing of additives, and the like.

In addition, in the two-step calcination, infrared rays are used. For example, when a heater (not shown) generating infrared rays is disposed below the substrate 10, and then the gel film is heated, it is possible to remove (degas) remaining organic components from the gel film, and to fire the composition while thermally decomposing, expanding, and contracting the gel film in a slow manner.

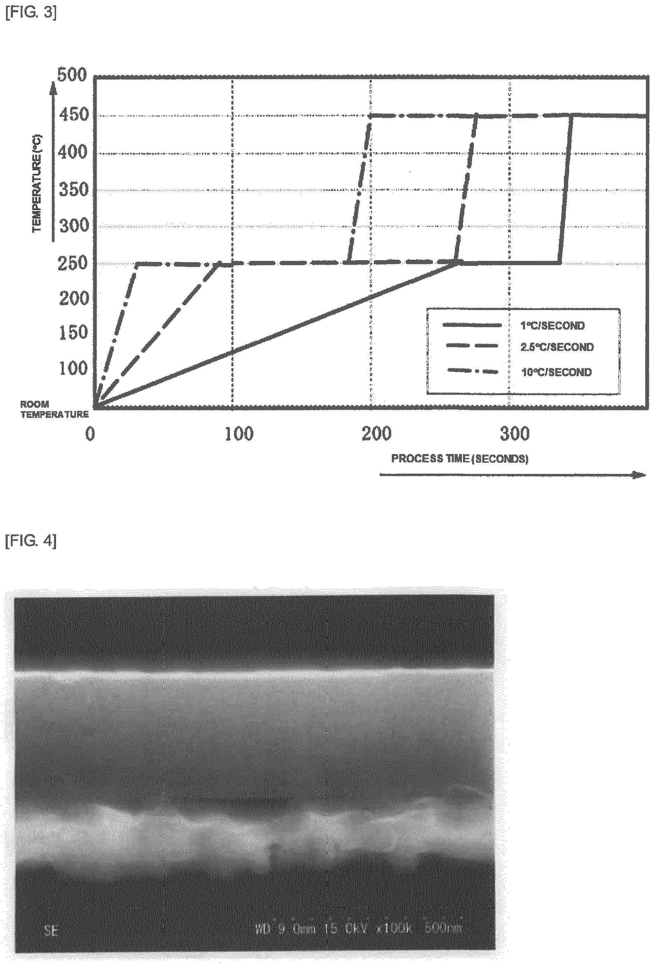

The temperature in accordance with the two-step calcination profile shown in Fig. 2 can be controlled by disposing the substrate 10 on an infrared heater, not shown, and using a temperature controlling apparatus, not shown, connected to the infrared heater. According to such temperature control, it is possible to appropriately change conditions of the temperature profile including the temperature-increase rate, the holding temperature, and the holding time. For example, as shown in Fig. 3, a temperature profile of the two-step calcination, in which any of three rates can be selected, is shown for the first temperature-increase rate during calcination in accordance with the temperature profile program-set in the temperature controlling apparatus in advance.

Furthermore, the conditions and reasons for the temperature profile for carrying out the two-step calcination will be described below in detail.

The main object of the first holding step is decomposition, combustion, and drying of a remaining organic substance such as a polymer or a solvent included in the solution of the PZT-based ferroelectric thin film composition. Therefore, when the holding temperature of the first holding step is too high, untargeted oxides are locally generated due to combustion and the like of the remaining organic component, and a dense and homogeneous film cannot be obtained. Therefore, the holding temperature is set to any of 200°C to 350°C (for example, 275°C) in the first holding step, and the composition is held for 1 minute to 5 minutes. The reason for the above is that decomposition of a precursor is not sufficiently accelerated at a holding temperature of the first holding step of lower than 200°C, and, when the holding temperature exceeds 350°C, decomposition proceeds too abruptly such that cracking occurs due to generation of voids derived from gas generation or stress derived from film contraction. In addition, when the holding time of the first holding step is less than 1 minute, the precursor substance does not decompose sufficiently, and when the holding time exceeds 5 minutes, the productivity deteriorates.

Furthermore, in the first holding step, the holding temperature is preferably set to any of 250°C to 300°C, and the composition is preferably held for 3 minutes to 5 minutes. The reason for the above is that, when the holding temperature of the first holding step is lower than 250°C, decomposition of a polymer or the like included in the precursor becomes insufficient, and generation of voids and the like are induced due to generation of gas, and, when the holding temperature exceeds 300°C, thermal decomposition abruptly proceeds, and there is a concern that cracks or voids may be generated. In addition, the holding time of the first holding step is set to 1 minute to 5 minutes. The reason for this is that, when the holding time of the first holding step is less than 1 minute, thermal decomposition is not sufficient, and, when the holding time exceeds 5 minutes, the productivity deteriorates.

In addition, the temperature is increased from the temperature in a temperature range of 0°C to 150°C (or room temperature) to the holding temperature of the first holding step at a temperature-increase rate of 1°C/second to 50°C/second (the first temperature-increase rate). The reason for the above is that, when the first temperature-increase rate is less than 1°C/second, the productivity deteriorates, and, when the first temperature-increase rate exceeds 50°C/second, there is a concern that some of the film may be crystallized due to overshoot. Furthermore, the first temperature-increase rate is preferably set to 2.5°C/second to 10°C/second. The reason for the above is that, when the first temperature-increase rate is less than 2.5°C/second, the productivity is poor, and, when the first temperature-increase rate exceeds 10°C/second, decomposition of the precursor abruptly proceeds excessively.

Next, the main object of the second holding step is removal of alkoxyl groups derived from a small amount of metal alkoxide, which cannot be removed in the first holding time, or organic ligands added as the stabilizer, or densification of an amorphous film. Therefore, in the second holding step, the holding temperature is set to any of 350°C to 500°C (for example, 450°C), and the composition is held for 5 minutes to 10 minutes. The reason for the above is that, when the holding temperature of the second holding step is lower than 350°C, unnecessary oxides are liable to be generated in the film if the decomposition is not sufficient, and, when the holding temperature exceeds 500°C, some of the film becomes a perovskite phase, and it becomes difficult to obtain an epitaxial-like film.

In addition, from the first holding step to when the second holding step is reached, densification of the film of the PZT-based ferroelectric thin film is made to proceed as much as possible. Therefore, the temperature is increased to the holding temperature of the second holding step at a temperature-increase rate of 1°C/second to 100°C/second (the second temperature-increase rate). The reason for the above is that, when the second temperature-increase rate is less than 1°C/second, the productivity is poor, and, when the second temperature-increase rate exceeds 100°C/second, untargeted oxides are generated in the film due to abrupt thermal decomposition. Furthermore, the second temperature-increase rate is preferably set to 2.5°C/second to 50°C/second. The reason for the above is that, when the second temperature-increase rate is less than 2.5°C/second, the productivity is poor, and, when the second temperature-increase rate exceeds 50°C/second, decomposition of the precursor substance abruptly proceeds, and densification does not proceed.

In addition, the holding time of the second holding step is set to 3 minutes to 20 minutes in order to sufficiently promote making the PZT-based ferroelectric thin film amorphous. The reason for this is that, when the holding time of the second holding step is less than 3 minutes, thermal decomposition of the precursor is not sufficient, and, when the holding time exceeds 3 minutes, the reaction sufficiently proceeds. Furthermore, the holding time of the second holding step is set to 3 minutes to 10 minutes. The reason for this is that, when the holding time of the second holding step is less than 3 minutes, thermal decomposition of the precursor is not sufficient, and, when the holding time exceeds 10 minutes, thermal decomposition is almost completed, and there is no large influence on the orientation of the film and the like.

### <Firing step>

The firing step is a step for firing the thin film of a PZT-based ferroelectric body obtained in the calcination step at a temperature which is the crystallization temperature or higher so as to crystallize the thin film, and a PZT-based ferroelectric thin film having a perovskite phase is obtained through this step. The firing atmosphere in the crystallization process is preferably O₂, N₂, Ar, N₂O, H₂, or a gas mixture thereof.

The firing is carried out at 450°C to 800°C for 1 minute to 60 minutes, and it is also possible to employ an RTA treatment in order to increase the production efficiency. The reason for the above is that, when the firing temperature is lower than 450°C, a perovskite phase cannot be obtained, and, when the firing temperature exceeds 800°C, the film characteristics deteriorate. In addition, when the firing time is less than 1 minute, the firing is not sufficient, and, when the firing time exceeds 60 minutes, the productivity deteriorates. The firing temperature and the firing time are preferably 600°C to 700°C and 1 minute to 5 minutes. The reason for the above is that, when the firing temperature is lower than 600°C, a highly crystalline film can be obtained only with a special solution or firing atmosphere, and, when the firing temperature exceeds 700°C, the film characteristics deteriorate. In addition, when the firing time is less than 1 minute, the firing is not sufficient, and, when the firing time exceeds 5 minutes, additional crystallization does not proceed without a special solution or firing atmosphere. In a case in which the composition is fired using an RTA treatment, the temperature-increase rate is set to 2.5°C/second to 150°C/second. In this case, the temperature-increase rate is preferably set to 10°C/second to 100°C/second. This is because, when the temperature-increase rate is less than 10°C/second, the productivity is poor, and, when the temperature-increase rate exceeds 100°C/second, it is difficult to control firing-related apparatuses.

When appropriately processed, the PZT-based ferroelectric thin film manufactured using the embodiment in the above manner can be used for a complex electronic component, such as a thin film capacitor, a capacitor, an IPD, a DRAM memory capacitor, a laminate capacitor, a gate insulator of a transistor, a non-volatile memory, a pyroelectric infrared detecting element, a piezoelectric element, an electro-optic element, an actuator, a resonator, an ultrasonic motor, or an LC noise filter element.

### [Examples]

Next, examples according to the invention will be described in detail with reference to Figs. 3, 4, 5, 6 and Tables 1 and 2 along with comparative examples according to a technique of the related art.

In the examples, 16 PZT-based ferroelectric thin films were obtained using a composition preparation step, a coating step, a calcination step through two-step calcination using infrared rays, and a firing step. On the other hand, in the comparative examples, 5 PZT-based ferroelectric thin films were obtained using a composition preparation step, a coating step, a calcination step not provided with a holding step of the related art, and a firing step. The conditions for the first holding temperatures, the first temperature-increase rates, the second holding temperatures, and the second temperature-increase rates in the calcination steps of the examples were summarized in Tables 1 and 2. Tables 1 and 2 summarize the values of the film thicknesses and the refractive indexes for the respective conditions after calcination and after firing, and the measuring method, the evaluation method, and the evaluation results will be described below.

The composition preparation step and the coating step are steps commonly included in all of the examples and the comparative examples, and were carried out in the following manner.

First, in the composition preparation step, a substance in which 24.24 g of Pb(CH₃COO)₃-3H₂O, 13.44 g of Zr(Oi-Pr)₄, and 7.64 g of Ti(Oi-Pr)₄ were dissolved in a mixed solution of ethanol and propylene glycol so that the Pb/Zr/Ti composition ratio became 115/52/48 (25 wt% in terms of an oxide) and to which acetyl acetone was added as a stabilizer was used as a raw material solution of a PZT-based ferroelectric thin film-forming composition. Furthermore, polyvinylpyrrolidone was added to this raw material solution so that the molar ratio of PZT polyvinylpyrrolidone became 1:0.5, and the solution was stirred for 24 hours at room temperature. In addition, N-methylformamide was added to the raw material solution so that the concentration became 7 wt%, the solution was stirred for 2 hours, and stabilized for 24 hours at room temperature.

Next, in the coating step, the solution obtained in the composition preparation step was added dropwise on a Si/SiO₂fTiO₂/Pt substrate set on a spin coater, and spin coating was carried out at 2000 rpm for 60 seconds, thereby forming a coated film. In addition, the coated film which was about to undergo the calcination step was heated on a hot plate at 150°C for 3 minutes, and the solvent having a low boiling point or absorbed moisture was removed, thereby obtaining a gel film.

### <Example 1>

In Example 1, the gel film obtained in the coating step was calcined using infrared rays in the calcination step of two-step calcination. As specific calcination conditions, the temperature was increased from 25°C to 275°C at a temperature-increase rate of 1°C/second, the gel film was held for 3 minutes, the temperature was increased to 450°C at a temperature-increase rate of 2.5°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 2>

In Example 2, the gel film obtained in the coating step was calcined using infrared rays in the calcination step of two-step calcination. As specific calcination conditions, the temperature was increased from 25°C to 275°C at a temperature-increase rate of 1°C/second, the gel film was held for 3 minutes, the temperature was increased to 450°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 3>

In Example 3, the gel film obtained in the coating step was calcined using infrared rays in the calcination step of two-step calcination. As specific calcination conditions, the temperature was increased from 25°C to 275°C at a temperature-increase rate of 1°C/second, the gel film was held for 3 minutes, the temperature was increased to 450°C at a temperature-increase rate of 25°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 4>

In Example 4, the gel film obtained in the coating step was calcined using infrared rays in the calcination step of two-step calcination. As specific calcination conditions, the temperature was increased from 25°C to 275°C at a temperature-increase rate of 1°C/second, the gel film was held for 3 minutes, the temperature was increased to 450°C at a temperature-increase rate of 50°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 5>

In Example 5, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 450°C at a temperature-increase rate of 2.5°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 6>

In Example 6, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 450°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 7>

In Example 7, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 450°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 8>

In Example 8, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 450°C at a temperature-increase rate of 50°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 9>

In Example 9, the gel film obtained in the coating step was calcined using infrared rays in the calcination step of two-step calcination. As specific calcination conditions, the temperature was increased from 25°C to 275°C at a temperature-increase rate of 10°C/second, the gel film was held for 3 minutes, the temperature was increased to 450°C at a temperature-increase rate of 2.5°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 10>

In Example 10, the gel film obtained in the coating step was calcined using infrared rays in the calcination step of two-step calcination. As specific calcination conditions, the temperature was increased from 25°C to 275°C at a temperature-increase rate of 10°C/second, the gel film was held for 3 minutes, the temperature was increased to 450°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 11>

In Example 11, the gel film obtained in the coating step was calcined using infrared rays in the calcination step of two-step calcination. As specific calcination conditions, the temperature was increased from 25°C to 275°C at a temperature-increase rate of 10°C/second, the gel film was held for 3 minutes, the temperature was increased to 450°C at a temperature-increase rate of 25°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 12>

In Example 12, the gel film obtained in the coating step was calcined using infrared rays in the calcination step of two-step calcination. As specific calcination conditions, the temperature was increased from 25°C to 275°C at a temperature-increase rate of 10°C/second, the gel film was held for 3 minutes, the temperature was increased to 450°C at a temperature-increase rate of 50°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 13>

In Example 13, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 450°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 14>

In Example 14, the gel film obtained in the coating step was calcined using infrared rays in the calcination step of two-step calcination. As specific calcination conditions, the temperature was increased from 25°C to 300°C at a temperature-increase rate of 2.5°C/second, the gel film was held for 3 minutes, the temperature was increased to 450°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 15>

In Example 15, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 425°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Example 16>

In Example 16, the gel film obtained in the coating step was calcined using infrared rays in the calcination step of two-step calcination. As specific calcination conditions, the temperature was increased from 25°C to 275°C at a temperature-increase rate of 2.5°C/second, the gel film was held for 3 minutes, the temperature was increased to 475°C at a temperature-increase rate of 10°C/second, and the gel film was held for 5 minutes. Next, in the firing step, the amorphous film obtained in the calcination step was fired at a temperature-increase rate of 5°C/second and 700°C for 5 minutes, and a PZT-based ferroelectric thin film was obtained.

### <Comparative example 1>

In Comparative example 1, the temperature of the gel film obtained in the coating step was increased to 400°C at a temperature-increase rate of 10°C/second in the calcination step of a single-step calcination of the related art, the gel film was held at this temperature for 8 minutes so as to be calcined, and then, in the firing step, the film obtained in the calcination step was fired under conditions of a temperature-increase rate of 10°C/second and 700°C for 5 minutes, thereby obtaining a PZT-based ferroelectric thin film.

### <Comparative example 2>

In Comparative example 2, the temperature of the gel film obtained in the coating step was increased to 450°C at a temperature-increase rate of 10°C/second in the calcination step of a single-step calcination of the related art, the gel film was held at this temperature for 8 minutes so as to be calcined, and then, in the firing step, the film obtained in the calcination step was fired under conditions of a temperature-increase rate of 10°C/second and 700°C for 5 minutes, thereby obtaining a PZT-based ferroelectric thin film.

### <Comparative example 3>

In Comparative example 3, the temperature of the gel film obtained in the coating step was increased to 475°C at a temperature-increase rate of 10°C/second in the calcination step of a single-step calcination of the related art, the gel film was held at this temperature for 8 minutes so as to be calcined, and then, in the firing step, the film obtained in the calcination step was fired under conditions of a temperature-increase rate of 10°C/second and 700°C for 5 minutes, thereby obtaining a PZT-based ferroelectric thin film.

### <Comparative example 4>

In Comparative example 4, the temperature of the gel film obtained in the coating step was increased to 500°C at a temperature-increase rate of 10°C/second in the calcination step of a single-step calcination of the related art, the gel film was held at this temperature for 8 minutes so as to be calcined, and then, in the firing step, the film obtained in the calcination step was fired under conditions of a temperature-increase rate of 10°C/second and 700°C for 5 minutes, thereby obtaining a PZT-based ferroelectric thin film.

### <Comparative example 5>

In Comparative example 5, the temperature of the gel film obtained in the coating step was increased to 450°C at a temperature-increase rate of 2.5°C/second in the calcination step of a single-step calcination of the related art, the gel film was held at this temperature for 8 minutes so as to be calcined, and then, in the firing step, the film obtained in the calcination step was fired under conditions of a temperature-increase rate of 10°C/second and 700°C for 5 minutes, thereby obtaining a PZT-based ferroelectric thin film.

### <Comparative example 6>

In Comparative example 6, the temperature of the gel film obtained in the coating step was increased to 450°C at a temperature-increase rate of 50°C/second in the calcination step of a single-step calcination of the related art, the gel film was held at this temperature for 8 minutes so as to be calcined, and then, in the firing step, the film obtained in the calcination step was fired under conditions of a temperature-increase rate of 10°C/second and 700°C for 5 minutes, thereby obtaining a PZT-based ferroelectric thin film.

### <Comparison tests>

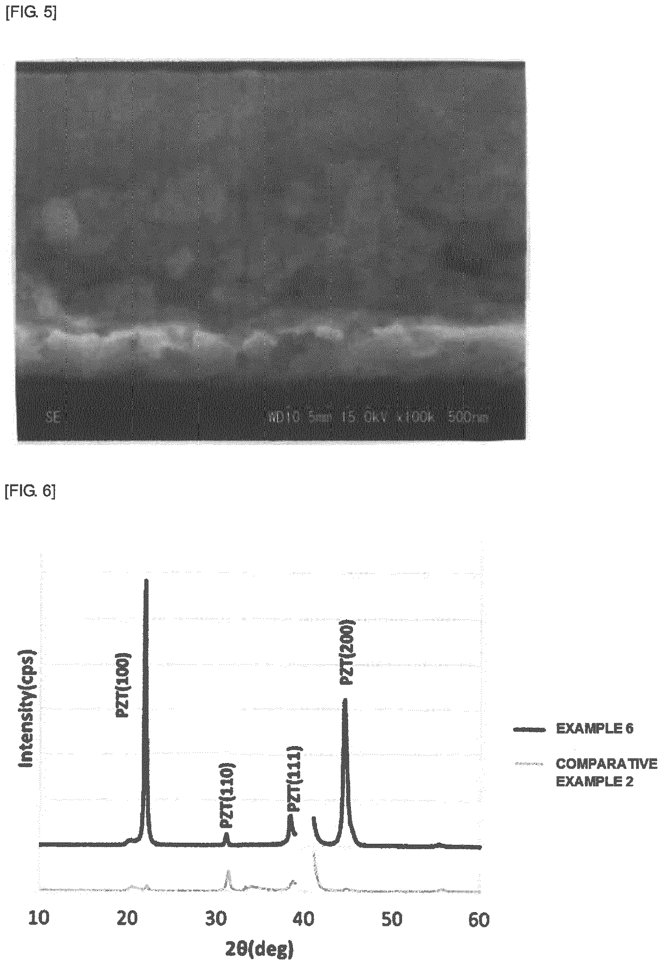

For the PZT-based ferroelectric thin films obtained in Examples 1 to 16 and Comparative examples 1 to 6, the layer thicknesses and refractive indexes of the thin films after calcination and after firing were obtained using the following method. The results are shown in Table 1. In addition, the cross-sectional SEM image (a magnification of 100,000 times) of Example 6 and the cross-sectional SEM image (a magnification of 100,000 times) of Comparative example 6 are shown in Figs. 4 and 5 respectively. In addition, the XRD charts of Example 6 and Comparative example 2 are shown in Fig. 6.
(1) Layer thickness measurement: the layer thickness of the obtained PZT-based ferroelectric thin film was measured using a spectroscopic ellipsometer (manufactured by J.A.Woollam Co., Inc.; M-2000), and the measurement results were summarized in Table 1.
(2) Refractive index measurement: the refractive index of the same thin film was measured using the same spectroscopic ellipsometer, and the measurement results were summarized in Table 2.
(3) Cross-sectional surface observation: the cross-sectional surface of the same thin film was observed using a photograph (a magnification of 100,000 times) photographed using a SEM (manufactured by Hitachi Science System, Ltd.; S-4300SE). Fig. 4 is a cross-sectional photograph of the thin film of Example 6, and Fig. 5 is a cross-sectional photograph of Comparative example 6.
(4) Crystal orientation: an XRD chart was produced using an X-ray diffraction apparatus (manufactured by Bruker AXS, MXP18VAHF) of Fig. 6 in order to investigate the crystal orientations and degrees of crystal completion of the PZT-based ferroelectric thin films obtained in Example 6 and Comparative example 2.

**[Table 1]**

| | First temperature-increase rate (°C/second) | Temperature of first holding step (°C) | Second temperature-increase rate (°C/second) | Temperature of second holding step (°C) | Layer thickness (nm) | |
|---|---|---|---|---|---|---|
| | | | | | After calcination | After firing |
| Example 1 | 1 | 275 | 2.5 | 450 | 357 | 320 |
| Example 2 | 1 | 275 | 10 | 450 | 360 | 345 |
| Example 3 | 1 | 275 | 25 | 450 | 352 | 308 |
| Example 4 | 1 | 275 | 50 | 450 | 366 | 314 |
| Example 5 | 2.5 | 275 | 2.5 | 450 | 342 | 309 |
| Example 6 | 2.5 | 275 | 10 | 450 | 346 | 310 |
| Example 7 | 2.5 | 275 | 25 | 450 | 352 | 314 |
| Example 8 | 2.5 | 275 | 50 | 450 | 382 | 331 |
| Example 9 | 10 | 275 | 2.5 | 450 | 388 | 332 |
| Example 10 | 10 | 275 | 10 | 450 | 393 | 350 |
| Example 11 | 10 | 275 | 25 | 450 | 379 | 330 |
| Example 12 | 10 | 275 | 50 | 450 | 389 | 314 |
| Example 13 | 2.5 | 275 | 10 | 450 | 369 | 324 |
| Example 14 | 2.5 | 300 | 10 | 450 | 389 | 351 |
| Example 15 | 2.5 | 275 | 10 | 425 | 375 | 329 |
| Example 16 | 2.5 | 275 | 10 | 475 | 345 | 323 |
| Comparative example 1 | 10 | 400 | - | - | 582 | 430 |
| Comparative example 2 | 10 | 450 | - | - | 458 | 396 |
| Comparative example 3 | 10 | 475 | - | - | 458 | 400 |
| Comparative example 4 | 10 | 500 | - | - | 481 | 412 |
| Comparative example 5 | 2.5 | 450 | - | - | 476 | 399 |
| Comparative example 6 | 50 | 450 | - | - | 572 | 382 |

**[Table 2]**

| | First temperature-increase rate (°C/second) | Temperature of first holding step (°C) | Second temperature-increase rate (°C/second) | Temperature of second holding step (°C) | Refractive index | |
|---|---|---|---|---|---|---|
| | | | | | After calcination | After firing |
| Example 1 | 1 | 275 | 2.5 | 450 | 2.20 | 2.43 |
| Example 2 | 1 | 275 | 10 | 450 | 2.26 | 2.42 |
| Example 3 | 1 | 275 | 25 | 450 | 2.28 | 2.46 |
| Example 4 | 1 | 275 | 50 | 450 | 2.21 | 2.44 |
| Example 5 | 2.5 | 275 | 2.5 | 450 | 2.14 | 2.42 |
| Example 6 | 2.5 | 275 | 10 | 450 | 2.26 | 2.46 |
| Example 7 | 2.5 | 275 | 25 | 450 | 2.28 | 2.46 |
| Example 8 | 2.5 | 275 | 50 | 450 | 2.26 | 2.46 |
| Example 9 | 10 | 275 | 2.5 | 450 | 2.29 | 2.42 |
| Example 10 | 10 | 275 | 10 | 450 | 2.24 | 2.41 |
| Example 11 | 10 | 275 | 25 | 450 | 2.25 | 2.43 |
| Example 12 | 10 | 275 | 50 | 450 | 2.24 | 2.46 |
| Example 13 | 2.5 | 275 | 10 | 450 | 2.2 | 2.43 |
| Example 14 | 2.5 | 300 | 10 | 450 | 2.23 | 2.41 |
| Example 15 | 2.5 | 275 | 10 | 425 | 2.18 | 2.45 |
| Example 16 | 2.5 | 275 | 10 | 475 | 2.41 | 2.45 |
| Comparative example 1 | 10 | 400 | - | - | 2.20 | 2.32 |
| Comparative example 2 | 10 | 450 | - | - | 2.17 | 2.34 |
| Comparative example 3 | 10 | 475 | - | - | 2.2 | 2.34 |
| Comparative example 4 | 10 | 500 | - | - | 2.19 | 2.36 |
| Comparative example 5 | 2.5 | 450 | - | - | 2.21 | 2.33 |
| Comparative example 6 | 50 | 450 | - | - | 2.08 | 2.35 |

Evaluation results will be described below with reference to Tables 1 and 2 and Figs. 4 to 6.

Considering the numeric values of the layer thickness column in Table 1, when the PZT-based ferroelectric thin films obtained in Examples 1 to 16 through two-step calcination using infrared rays and the PZT-based ferroelectric thin films obtained in Comparative examples 1 to 6 through single-step calcination not using infrared rays are compared, the layer thicknesses after calcination become thinner in Examples 1 to 16 than in Comparative examples 1 to 6. This is considered to indicate that the PZT-based ferroelectric thin films obtained by calcining the gel films of Examples 1 to 16 become dense. In addition, the difference between the layer thickness after calcination and the layer thickness after firing becomes smaller in Examples 1 to 16 than in Comparative examples 1 to 6. This is assumed that, since the thermal contraction rate between calcination and firing becomes lower in the PZT-based ferroelectric thin films of Examples 1 to 16 than in Comparative examples 1 to 6, it is more difficult for cracking to occur in the PZT-based ferroelectric thin films of Examples 1 to 16 than in Comparative examples 1 to 6. Furthermore, the results show that it becomes possible to provide a method of manufacturing a PZT-based ferroelectric thin film through which a film thickness of 100 nm or more can be obtained without cracking by coating a PZT-based ferroelectric thin film composition once on the surface of a lower electrode.

Considering the numeric values in the refractive index column in Table 2, Examples 1 to 16 generally have higher values than Comparative examples 1 to 6. This is considered to be because the crystallinity is improved and the refractive index is improved by carrying out two-step calcination.

In addition, among the examples, the layer thicknesses and the refractive indexes are considered with reference to Tables 1 and 2 for Examples 4, 8 and 12 which follow the temperature profile of the two-step calcination step as shown in Fig. 3. In Examples 4, 8 and 12, the first temperature-increase rates are 1°C/second, 2.5°C/second, and 10°C/second, the first holding temperatures are 275°C, the second temperature-increase rates are 50°C/second, and the second holding temperatures are 450°C.

The layer thicknesses after calcination of Examples 4, 8 and 12 were 366 nm, 382 nm, and 389 nm, the layer thicknesses after firing were 314 nm, 331 nm, and 314 nm respectively, and there was a tendency for the layer thicknesses after calcination to increase as the first temperature-increase rate increases, however, there was no significant difference in the layer thicknesses after firing. In addition, the refractive indexes after calcination in Examples 4, 8 and 12 were 2.21, 2.26 and 2.24, the refractive indexes after firing were 2.44, 2.46 and 2.46 respectively, and there was no significant difference between the examples. It is found from the above results that no disadvantage occurred even when the first temperature-increase rate was set to 10°C/second which was the maximum temperature-increase rate among in the examples. Considering the production efficiency, the temperature-increase rate is preferably high; however, when the temperature-increase rate is set to too large, a problem of the related art, such as the occurrence of cracking, may occur, which is considered to be not preferable.

Furthermore, when referring to Figs. 4 and 5, it is found that, regarding the PZT-based ferroelectric thin films (corresponding to the layer having a reference numeral of 12 in Fig. 1) observed from the SEM cross-sectional photograph, the PZT-based ferroelectric thin film obtained in Example 6 formed an evidently dense crystal structure, but it was found that fine cracking occurred, and a non-dense and coarse crystal structure was formed in the PZT-based ferroelectric thin film obtained in Comparative example 6.

In addition, when referring to Fig. 6, Examples 1 to 16 had favorable crystallinity, but Comparative examples 1 to 6 were film which were not oriented and had a low crystallinity. Thereby, it was found that a dense and highly crystalline film can be obtained by introducing two-step calcination using infrared rays.

Thereby, it was found that, according to the method of manufacturing a PZT-based ferroelectric thin film through two-step calcination using infrared rays of the invention, it is possible to manufacture a crack-free, dense, and favorably crystalline PZT-based ferroelectric thin film even when a relatively thick layer having a layer thickness of 100 nm or more is coated once, calcined, and fired.

### [Industrial Applicability]

The method of manufacturing a PZT-based ferroelectric thin film of the invention enables coating, calcination, and firing at a thickness per layer approximately 5 times to 10 times the thickness per layer in the manufacturing method of the related art, and can provide a PZT-based ferroelectric thin film which is preferable for use in which a film thickness of 1 µm to 3 µm is required, for example, thin film piezoelectric use, at a low cost, dense, and excellent in terms of crystallinity.

### [Description of Reference Numerals and Signs]

- 10:: SUBSTRATE
- 11:: LOWER ELECTRODE
- 12:: FERROELECTRIC THIN FILM
- 13:: FIRST TEMPERATURE-INCREASE RATE
- 14:: FIRST HOLDING TEMPERATURE
- 15:: SECOND TEMPERATURE-INCREASE RATE
- 16:: SECOND HOLDING TEMPERATURE
- 17:: TEMPERATURE-INCREASE RATE OF THE RELATED ART
- 18:: HOLDING TEMPERATURE OF THE RELATED ART

## Claims

1. A method of manufacturing a PZT-based ferroelectric thin film on a lower electrode by coating, calcining, and then firing so as to crystallize a PZT-based ferroelectric thin film-forming composition on the lower electrode of a substrate having the lower electrode in which a crystal plane is oriented in a (111) axis direction, wherein
the calcination is carried out using infrared rays, and with the calcination comprising at least
a first holding step in which a temperature of the composition is increased from a temperature in a temperature range of 0°C to 150°C and the composition is held at a temperature in a temperature range of 250°C to 350°C, and
a second holding step in which a temperature of the composition is increased from a holding temperature of the first holding step and the composition is held at a temperature in a temperature range of 350°C to 500°C, which is higher than the holding temperature of the first holding step.

2. The method of manufacturing a PZT-based ferroelectric thin film according to Claim 1,
wherein a first temperature-increase rate until the first holding step is reached is in a range of 1°C/second to 10°C/second, and a second temperature-increase rate until the temperature is increased from the first holding step and the second holding step is reached is in a range of 1°C/second to 100°C/second.

3. The method of manufacturing a PZT-based ferroelectric thin film according to Claim 1 or 2,
wherein a holding temperature during the firing is in a temperature range of 550°C to 800°C, and a temperature-increase rate through the holding time is in a range of 2.5°C/second to 150°C/second.

## Patentansprüche

1. Verfahren zur Herstellung einer PZT-basierten ferroelektrischen Dünnschicht auf einer unteren Elektrode durch Beschichten, Kalzinieren und dann Brennen, um eine PZT-basierte ferroelektrische Dünnschicht-bildende Zusammensetzung auf der unteren Elektrode eines Substrats, das die untere Elektrode aufweist, in der eine Kristallebene in einer (111) Achsenrichtung orientiert ist, zu kristallisieren, wobei
das Kalzinieren durch die Verwendung von Infratrotstrahlen durchgeführt wird und das Kalzinieren mindestens
einen ersten Halteschritt, in dem die Temperatur der Zusammensetzung von einer Temperatur im Bereich von 0 °C bis 150 °C gesteigert wird und die Zusammensetzung bei einer Temperatur im Bereich von 250 °C bis 350 °C gehalten wird, und
einen zweiten Halteschritt, in dem die Temperatur von der Haltetemperatur des ersten Halteschrittes gesteigert wird und die Zusammensetzung bei einer Temperatur im Bereich von 350 °C bis 500 °C, die höher als die Haltetemperatur des ersten Halteschrittes ist, gehalten wird, umfasst.

2. Das Verfahren zur Herstellung einer PZT-basierten ferroelektrischen Dünnschicht nach Anspruch 1, wobei
die erste Temperatursteigerungsgeschwindigkeit bis zum Erreichen des ersten Halteschrittes in einem Bereich von 1 °C / Sekunde bis 10 °C / Sekunde ist und die zweite Temperatursteigerungsgeschwindigkeit des Anstiegs vom ersten Halteschritt bis zum Erreichen des zweiten Halteschrittes in einem Bereich von 1 °C / Sekunde bis 100 °C / Sekunde ist

3. Das Verfahren zur Herstellung einer PZT-basierten ferroelektrischen Dünnschicht nach Anspruch 1 oder 2, wobei
die Haltetemperatur während des Brennens im Bereich von 550 °C bis 800 °C ist und die Temperatursteigerungsgeschwindigkeit während der Haltezeit im Bereich von 2,5 °C / Sekunde bis 150 °C / Sekunde ist.

## Revendications

1. Procédé de fabrication d'un film ferroélectrique mince à base de PZT sur une électrode inférieure par revêtement, calcination, puis cuisson de manière à cristalliser une composition formant un film ferroélectrique mince à base de PZT sur l'électrode inférieure d'un substrat ayant l'électrode inférieure où un plan cristallin est orienté dans une direction d'axe (111), où
la calcination est effectuée en utilisant des rayons infrarouges, et la calcination comprenant au moins
une première étape de maintien dans laquelle une température de la composition est augmentée à partir d'une température se trouvant dans une plage de températures allant de 0°C à 150°C et la composition est maintenue à une température se trouvant dans une plage de températures allant de 250°C à 350°C, et
une deuxième étape de maintien dans laquelle une température de la composition est augmentée à partir d'une température de maintien de la première étape de maintien et la composition est maintenue à une température se trouvant dans une plage de températures allant de 350°C à 500°C, qui est supérieure à la température de maintien de la première étape de maintien.

2. Procédé de fabrication d'un film ferroélectrique mince à base de PZT selon la revendication 1,
dans lequel une première vitesse d'augmentation de température jusqu'à ce que la première étape de maintien soit atteinte se trouve dans une plage allant de 1°C/seconde à 10°C/seconde, et une deuxième vitesse d'augmentation de température jusqu'à ce que la température soit augmentée à partir de la première étape de maintien et que la deuxième étape de maintien soit atteinte se trouve dans une plage allant de 1°C/seconde à 100°C/seconde.

3. Procédé de fabrication d'un film ferroélectrique mince à base de PZT selon la revendication 1 ou 2,
dans lequel une température de maintien au cours de la cuisson se trouve dans une plage de températures allant de 550°C à 800°C et une vitesse d'augmentation de température pendant la durée de maintien se trouve dans une plage allant de 2,5°C/seconde à 150°C/seconde.
